# EUROPÄISCHE PATENTSCHRIFT

(11) **EP 3 380 645 B1**
(45) Veröffentlichungstag und Bekanntmachung des Hinweises auf die Patenterteilung: **01.05.2024**
(21) Anmeldenummer: 16809300.3
(22) Anmeldetag: 25.11.2016
(51) Int. Cl.: C23C 16/27, C23C 28/04, C23C 14/02, C23C 16/02, C23C 28/00

(54) **BESCHICHTUNG EINES KÖRPERS MIT DIAMANTSCHICHT UND HARTSTOFFSCHICHT**
COATING A BODY WITH A LAYER OF DIAMOND AND A LAYER OF HARD MATERIAL
REVÊTEMENT D'UN CORPS AVEC UNE COUCHE DE DIAMANT ET UNE COUCHE DE MATÉRIAU DUR

(30) Priorität: 27.11.2015 DE 102015120676
(43) Veröffentlichungstag der Anmeldung: 03.10.2018
(73) Patentinhaber: CemeCon AG, 52146 Würselen (DE)
(72) Erfinder: BOLZ, Stephan, 52072 Aachen (DE); LEMMER, Oliver, 52066 Aachen (DE); LEYENDECKER, Antonius, 52134 Herzogenrath (DE)
(74) Vertreter: Kalkoff & Partner Patentanwälte mbB
(86) Internationale Anmeldenummer: PCT/EP2016/078912
(87) Internationale Veröffentlichungsnummer: WO 2017/089597

(56) Entgegenhaltungen:
- WO-A1-2011/135100
- DE-A1-102005 056 937
- DE-A1-102011 080 898

## Beschreibung

Die Erfindung betrifft einen beschichteten Körper nach Anspruch 1 und ein Verfahren zur Beschichtung eines Körpers nach Anspruch 12.

Es ist bekannt, Körper oder Teile von Körpern mit einer Oberflächenbeschichtung zur Verbesserung der Eigenschaften zu versehen. Insbesondere für Werkzeuge und für Bauteile, die einem Verschleiß unterliegen, ist es bekannt, Funktionsflächen mit Beschichtungen zu versehen.

Verschleißschutz kann beispielsweise durch auf Funktionsflächen aufgebrachte Körper erzielt werden. Bekannt ist z.B. die Verwendung von Sinterkörpern aus polykristallinem Diamant (PKD, auch bezeichnet als PCD). Beispielsweise offenbart die US 5 833 021_ein Schneidelement für einen Erdbohrer, bei dem auf einem zylindrischen HartmetallKörper ein PKD-Element auf der Schneidfläche aufgesintert ist. Zur Verlängerung der Lebensdauer ist zudem eine Hartstoffschicht auf die PKD-Oberfläche aufgebracht. Als Beschichtungsmaterialien sind TiN, TiC, TiCN, TiAlCN, TiAlN, B₄C, CrN, CrC, ZrC oder eines der Übergangsmetalle oder Metalle der Gruppe IV kombiniert mit Silizium, Aluminium, Bor, Kohlenstoff, Stickstoff oder Sauerstoff zur Bildung eines Silicids, Aluminids, Borids, Karbids, Nitrids, Oxids oder Carbonitrids eines Metalls genannt. Die PCD-Oberfläche kann vorbehandelt werden durch selektives Ätzen oder durch Behandlung mit reaktivem Metall, bspw. mittels Laser sputtering, Ionenbeschuss oder Plasmaätzen. Die Schicht kann mittels CVD, MOCVD, PVD, sputtering aufgebracht werden. Im Fall eines großen Unterschieds des thermischen Ausdehnungskoeffizienten zwischen der Beschichtung und der PCD-Schicht können Zwischenschichten vorgesehen sein, um eine allmähliche Änderung des Ausdehnungskoeffizienten zu erreichen.

Die DE 10 2010 006 267 A1_beschreibt ein Verfahren sowie ein Schichtsystem für Werkzeuge mit PKD-Körpern, d.h. synthetisch hergestellten, extrem fest zusammengefügten Massen von Diamantkristallen, die durch einen Sinterprozess mit einem metallischen Bindermaterial hergestellt sind. Ein PKD-Grundkörper ist im Allgemeinen auf einem Hartmetall-Substrat aufgebracht. Die PKD-Oberfläche wird durch hoch energetische und gepulste Metallionen-Strahlen aktiviert und durch Metallionenätzen vorbehandelt. Eine reaktiv wirkende, Karbid bildende metallische Grundlage z. B. Cr, Ti wird aufgebracht, darauf eine Haftvermittlerlage, darauf eine Hartstoff-Decklage, z. B. TiAlN. Jeweils eine Übergangsschicht ist zwischen den einzelnen Schichtlagen angeordnet.

Zur Bildung von dünnen Beschichtungen sind einerseits CVD-Verfahren bekannt, d. h. Verfahren der chemischen Gasphasenabscheidung, bei denen auf der Oberfläche eines Substrats ein Feststoff aus der Gasphase abgeschieden wird. Mittels CVD-Verfahren können verschiedene Schichten und Schichtsysteme auf der Oberfläche eines Substrats erzeugt werden. Eine besondere Rolle spielen dabei synthetische Diamantschichten, die aus einer Atmosphäre mit Kohlenstoff und Wasserstoff abgeschieden werden.

Diamantschichten können insbesondere für die Verwendung auf Funktionsflächen von verschleißbehafteten Bauteilen und Werkzeugen von erheblichem Vorteil sein. Sie sind chemisch weitgehend inert und weisen außerordentlich hohe Härte auf. Allerdings zeigen sich bspw. bei Werkzeugen mit diamantbeschichteter Funktionsfläche in einigen Fällen auch Probleme. Bei hohen Temperaturen kann es zu einer Oxidation der Schicht kommen. Bei der Bearbeitung bspw. von eisenhaltigen Gusswerkstoffen kann chemischer Verschleiß auftreten.

Eine andere Klasse von Beschichtungen wird durch PVD-Beschichtungsverfahren und die hiermit abgeschiedenen Schichten gebildet. Es sind verschiedene PVD-Verfahren, insbesondere Lichtbogenverdampfen und Sputtern bekannt, mit denen insbesondere Hartstoffschichten auf einem Substrat abgeschieden werden können.

Die US 5 543 210_offenbart ein Schneidwerkzeug mit einem Hartmetall- oder Keramickörper und einer Diamantschicht sowie einer Schicht aus Chromnitrid, Chromcarbid oder Chromcarbonitrid. Die Diamantschicht kann in direkten Kontakt mit dem beschichteten Körper stehen oder davon getrennt sein durch eine Schicht aus metallischem oder abriebfestem Material. Die Dicke der Diamantschicht beträgt 1 bis 20 µm, bevorzugt 4 bis 15 µm und die Dicke der chromhaltigen Schicht 0,1 bis 5 µm. Die Korngröße der Diamantschicht liegt bevorzugt bei 3 bis 10 µm. Die Diamantschicht kann mit einem bekannten CVD oder PVD-Beschichtungsverfahren erzeugt werden. Die chromhaltige Schicht kann durch jedes bekannte CVD- oder PVD-Verfahren aufgebracht werden, bevorzugt durch Ion Plating.

Die JP 2003 - 145 309_offenbart ein diamantbeschichtetes Schneidwerkzeug mit einem Grundkörper aus Hartmetall. In einer Mikrowellen-CVD-Anlage wird eine Diamantschicht von ca. 20 µm aufgebracht. Eine TiN-Schicht von 0,3 µm Dicke wird mittels Arc Ion Plating aufgebracht und eine TiAlN-Schicht einer Dicke von etwa 4 µm wird weiter aufgebracht.

Die den jeweiligen Oberbegriff der Ansprüche 1 und 12 bildende DE 10 2005 056 937 A1 beschreibt eine harte Beschichtung auf der Oberfläche eines Körpers. Dieser umfasst eine Diamantschicht, die mehrere Diamantkörner enthält und mit Bor dotiert ist. Eine äußere Schicht auf der Diamantschicht ist durch Abscheidung aus der Dampfphase aufgebracht und enthält eine intermetallische Verbindung. In einer Ausführungsform besteht die obere Schicht der harten Beschichtung aus zwei Schichten, einer TiN-Schicht mit einer Dicke von 0,3 µm, aufgebracht auf der Diamantschicht, und einer TiAlN-Schicht mit einer Dicke von 4 µm, aufgebracht auf der TiN-Schicht. Die TiN-Schicht und die TiAlN-Schicht werden beide durch Lichtbogenionenplattieren aufgebracht.

Die DE 10 2011 080 898 offenbart ein Beschichtungssystem für metallische Werkstücke. Auf einem metallischen Werkstück z. B. auf Stahl, Aluminium oder Titan wird zum Schutz vor mechanischem Verschleiß, z. B. in Maschinenkomponenten, zunächst eine haftvermittelnde Schicht und darauf eine funktionsgebende Schicht aufgebracht. Die haftvermittelnde Schicht kann metallische Schichten, aber auch Verbindungsschichten oder Mischschichten mit Metallen mit den Elementen Sauerstoff, Stickstoff, Kohlenstoff, Wasserstoff umfassen und wird mittels des HIPIMS-Verfahrens aufgebracht. Die Implantation der Metalle Chrom, Titan, Niob und weitere Übergangsmetalle gehen starke Bindungen mit den Atomen des metallischen Werkstücks ein und die Schicht kann ebenfalls die Glättung der Oberfläche gewährleisten.

In der WO 2011 135100 A1 ist ein Körper beschrieben mit einem Substrat, einer darauf aufgebrachten Zwischenschicht und einer auf der Zwischenschicht aufgebrachten CVD-Diamantschicht. Die Diamantschicht ist überwiegend metallisch, wobei der Metallanteil überwiegend aus Wolfram und/oder Chrom besteht. Die Zwischenschicht weist eine Rauheit mit einem RZ-Wert von 0,5 - 3,0 µm auf.

Es ist Aufgabe der Erfindung, einen beschichteten Körper und ein Verfahren zur Beschichtung eines Körpers anzugeben, die insbesondere für Werkzeuge und verschleißbehaftete Bauteile günstige Eigenschaften aufweisen.

Die Aufgabe wird gelöst durch einen beschichteten Körper gemäß Anspruch 1 und ein Verfahren gemäß Anspruch 12. Abhängige Ansprüche beziehen sich auf vorteilhafte Ausführungsformen der Erfindung.

Der erfindungsgemäße Körper umfasst ein Substrat, mindestens eine Diamantschicht und mindestens eine Hartstoffschicht. Gemäß dem erfindungsgemäßen Verfahren kann eine Beschichtung des Körpers vorgenommen werden, indem zunächst eine Diamantschicht mittels eines CVD-Verfahrens aufgebracht und anschließend oberhalb der Diamantschicht eine Hartstoffschicht mittels eines PVD-Verfahrens aufgebracht wird.

Bei den Substraten handelt es sich bevorzugt um Grundkörper eines Werkzeugs oder eines verschleißbehafteten Bauteils, bspw. eines Lagerbauteils. Besonders bevorzugt handelt es sich um ein Schneidwerkzeug, insbesondere mit bestimmter Schneide. Der Werkstoff des Substrats kann bspw. Stahl, z. B. HSS-Stahl, gesintertes Hartmetall, gesintertes Bornitrid, gesintertes Diamant-Material, Cermet oder Keramik sein. Bevorzugt ist die Verwendung von Substraten aus Hartmetall mit gesinterten Wolframkarbid-Körnern in einem cobalthaltigen Matrixmaterial.

Der erfindungsgemäße Körper weist weiter eine Diamantschicht auf, d.h. eine Schicht, die zu mindestens 75% des Schichtvolumens aus Diamantkristallen besteht, bevorzugt zu mindestens 90%, besonders bevorzugt zu mindestens 95%. Die Schicht ist mindestens auf einen Teil der Oberfläche des Körpers aufgebracht, insbesondere auf einer Funktionsfläche eines Werkzeugs. Bevorzugt ist die Diamantschicht mindestens auf der Funktionsfläche geschlossen. Die Diamantschicht kann bspw. direkt auf dem oben genannten Substratmaterial angeordnet sein, oder es können eine oder mehrere Zwischenschichten zwischen dem Substratmaterial und der Diamantschicht angeordnet sein. Insbesondere bei Substraten aus Stahl ist eine Zwischenschicht bevorzugt. Bei Hartmetall-Substraten können Substratbestandteile, die für die Schichthaftung ungünstig sind, wie bspw. Cobalt, bspw. durch eine chemische Vorbehandlung ganz oder teilweise entfernt werden. Im Fall einer Zwischenschicht kann eine solche chemische Vorbehandlung entfallen.

Die Diamantschicht kann in einem CVD-Verfahren abgeschieden werden, besonders bevorzugt im Hot-Filament-Verfahren. Sie weist bevorzugt eine Dicke im Mikrometerbereich auf, bspw. 1 - 40 µm, bevorzugt 2 - 20 µm.

Oberhalb der Diamantschicht, d. h. weiter außen am Körper als diese, ist erfindungsgemäß eine Hartstoffschicht angeordnet. Darunter werden Schichten aus Materialien von besonders hoher Härte verstanden, insbesondere Boride und Nitride von Metallen ausgewählt aus der Gruppe umfassend Al, Si und Metalle der Gruppen 4-6 des Periodensystems nach IUPAC (2013). Zu den Hartstoffen werden hier auch undotiertes oder metalldotiertes DLC oder Aluminiumoxid gezählt.

Zwischen der Hartstoffschicht und der Diamantschicht können eine oder mehrere dazwischen angeordnete Schichten vorgesehen sein. Insbesondere ist bei dem erfindungsgemäßen beschichteten Körper eine Haftschicht eine Dicke von 2 - 80 nm vorgesehen, um die Haftung der Hartstoffschicht auf der Diamantschicht zu verbessern. Die Haftschicht ist erfindungsgemäß gebildet durch Implantation oder Diffusion von Metallatomen in einer äußeren Zone der Diamantschicht.

Die Hartstoffschicht weist erfindungsgemäß mindestens ein metallisches Element und mindestens ein nichtmetallisches Element auf. Sie kann insbesondere zusammengesetzt sein aus einem oder mehreren metallischen Element und einem oder mehreren nichtmetallischen Elementen. Bevorzugt sind dabei Zusammensetzungen, bei denen das metallische Element oder die metallischen Elemente ausgewählt sind aus der Gruppe umfassend Al, Si und Elemente der Gruppen 4-6 des Periodensystems nach IUPAC (1988). Besonders bevorzugt ist als metallisches Element Ti enthalten. Die nichtmetallischen Elemente können bspw. ausgewählt werden aus der Gruppe umfassend B, N und O, besonders bevorzugt ist N als einziges nichtmetallisches Element vorgesehen.

Die Hartstoffschicht kann ein- oder mehrlagig ausgebildet sein, wobei sich verschiedene übereinander angeordnete Lagen durch die Zusammensetzung und/ oder Struktur voneinander unterscheiden können.

In den nachfolgenden Darstellungen werden die Zusammensetzungen von Schichten entweder direkt als chemische Verbindungen bzw. Phase oder als Materialsysteme genannt. Materialsysteme werden dabei bezeichnet durch Auflistung der darin enthaltenen Elemente, jeweils durch einen Bindestrich voneinander getrennt, wobei zunächst die metallischen Elemente und danach die nichtmetallischen Elemente angegeben sind. Dabei werden bevorzugt jeweils nacheinander die metallischen und nichtmetallischen Elemente in der Reihenfolge entsprechend ihrem Anteil (in Atomprozent) genannt. Die Angabe des Materialsystems kann dabei der chemischen Verbindung entsprechen, dies ist aber nicht in allen Fällen so. Beispielsweise wird das Materialsystem Ti-C die Hartstoffverbindung TiC enthalten oder vollständig hieraus bestehen, während das Materialsystem Ti-B die Hartstoffverbindung TiB₂ umfasst oder hieraus besteht und das Materialsystem Cr-C bspw. eine Mischung aus den Hartstoffverbindungen Cr₂₃C₆, Cr₇C₃ und bevorzugt Cr₃C₂ sein kann.

Die gesamte Hartstoffschicht oder mindestens eine der Lagen kann bevorzugt bestehen aus einem Materialsystem ausgewählt aus der Gruppe umfassend Ti-Al-N, Ti-N, Ti-C-N, Ti-Al-C-N, Ti-Al-Si-N, Ti-Si-N, Al-Cr-N, Al-Cr-Si-N, Ti-Ta-N, Ti-B. Es kann auch eine oder mehrere Lagen der Hartstoffschicht aus DLC ohne oder bevorzugt mit einer Metalldotierung bestehen. Die Hartstoffschicht beinhaltet bevorzugt einen hohen Anteil an in dem jeweiligen Materialsystem gebildeten Hartstoffverbindungen, bspw. Metallnitride oder Metallcarbide.

Die Dicke einzelner Lagen liegt bspw. im Nanometerbereich, bevorzugt bei 0,5 - 30 nm, weiter bevorzugt bei 0,5 - 15 nm, besonders bevorzugt bei 0,5 - 5 nm. In einer Ausführungsform weist die Hartstoffschicht eine Nano-Multilayerstruktur auf, d.h. sie besteht vollständig aus Einzellagen, die jeweils eine Dicke im oben angegebenen Bereich aufweisen. In anderen Ausführungsformen kann die Dicke von allen oder einzelnen Lagen auch im Mikrometerbereich liegen. So kann bspw. eine 1-2 µm dicke Schicht aus Ti-Al-N durch eine darüber liegende Schicht einer Dicke von 1-2 µm aus Ti-Si-N gut vor Oxidation geschützt werden.

Bei der bevorzugten Erzeugung der Hartstoffschicht im PVD-Verfahren ergibt sich eine Schicht, die im Gegensatz zu einer durch ein CVD-Verfahren hergestellten Schicht Druckspannungen aufweist und frei ist von Verunreinigungen durch Halogene. Besonders bevorzugt ist eine in einem Sputter-Verfahren erzeugte Hartstoffschicht, die im Gegensatz zu mit einem Verfahren der Lichtbogenverdampfung (Arc) hergestellten Schicht frei von Droplets ist.

Die Gesamtdicke der Hartstoffschicht liegt bevorzugt im Mikrometerbereich. Bevorzugt ist die Schichtdicke der Hartstoffschicht geringer als die Schichtdicke der Diamantschicht, bspw. mindestens 20 % geringer, bevorzugt mindestens 40%, besonders bevorzugt mindestens 60% geringer. Bevorzugt kann die Gesamtdicke der Hartstoffschicht 1-12 µm betragen, weiter bevorzugt 2 - 6 µm.

Die erfindungsgemäße Schichtstruktur mit einer Hartstoffschicht oberhalb einer Diamantschicht kann erhebliche Vorteile, insbesondere bei der Verwendung als Werkzeug bringen. Oxidationsbeständige Hartstoffschichten, wie bspw. Ti-Al-N, Ti-Al-Cr-N, Cr-N und Al₂O₃ können bspw. beim Einsatz des Körpers als Werkzeug einen Kontakt der Diamantschicht mit Sauerstoff vermindern oder unterbinden, so dass auch bei höheren Temperaturen eine Oxidation der Diamantschicht verringert oder vollständig vermieden wird. Auch eine Dotierung der Hartstoffschicht oder einer oder mehrerer Lagen hiervon mit Si kann die Oxidationsbeständigkeit verbessern. Beispiele solcher Schichten wären Ti-Si-N, Ti-Al-Si-N, Cr-Al-Si-N oder Multilayer-Strukturen mit bspw. abwechselnden Lagen aus Ti-Al-N und Ti-Si-N. Ähnliche Vorteile ergeben sich auch beim Einsatz eines Werkzeugs mit der erfindungsgemäßen Struktur für die Bearbeitung von Werkstoffen, die Fe, Co und/oder Ni enthalten, wie insbesondere Stahl und eisenhaltige Gusswerkstoffe. Die erfindungsgemäß oberhalb der Diamantschicht vorgesehene Hartstoffschicht, insbesondere wenn diese als Nitrid, Carbid oder Carbonitrid ausgebildet ist, bspw. als Ti-Al-N oder Al-Ti-Cr-N kann hier die Diamantschicht vor chemischem Verschleiß mindestens zum Teil schützen.

Generell ist der Schichtaufbau aus einer Diamantschicht und weiter außen angeordneten Hartstoffschicht günstig, weil die Diamantschicht mit ihrer außerordentlich hohen Härte und dem hohen Elastizitätsmodul einen äußerst stabilen und harten Unterbau für die darüber aufgebrachte Hartstoffschicht bildet. Einem "Eierschaleneffekt", d. h. ein Durchbrechen der PVD-Schicht bei starken mechanischen Belastungen kann hiermit entgegengewirkt werden.

Es ist auch möglich, dass der Unterbau in Form der Diamantschicht die thermische Belastung der PVD-Schicht und des Substrats reduziert, bspw. beim Einsatz als Zerspanungswerkzeug. Hierdurch kann die Lebensdauer der PVD-Schicht erhöht und eine plastische Verformung des Substrats sowie ein Schneidkantenversatz vermindert oder vermieden werden. Eine Reduktion der thermischen Belastung kann durch die gute Wärmeleitung der Diamantschicht erreicht werden. Diese kann Werte bis hin zur außerordentlich hohen Wärmeleitfähigkeit des natürlichen Diamanten von 2100 W/Km erreichen. Je nach Schichtstruktur der Diamantschicht, die, wie nachfolgend näher erläutert wird, aus mehreren Lagen von Diamant verschiedener Struktur aufgebaut sein kann, können sich aber auch geringere Werte für die thermische Leitfähigkeit ergeben. Dabei nimmt die Leitfähigkeit durch Korngrenzen der einzelnen Diamantkristalle ab. Insbesondere im Fall von nanokristallinen Diamantschichten oder -lagen ergeben sich durch die Vielzahl an Komgrenzen geringere Wärmeleitfähigkeiten, die aber immer noch einen günstigen Einfluss auf die thermischen Verhältnisse in der Hartstoffschicht haben können. Bevorzugt wird in der Diamantschicht eine gemittelte Wärmeleitfähigkeit von mehr als 120 W/Km erzielt, bevorzugt höher als 200 W/Km, besonders bevorzugt höher als 500 W/Km. Die Wärmeleitfähigkeiten erweisen sich dabei als deutlich temperaturabhängig; die angegebenen Werte sind als Wärmeleitfähigkeit bei Raumtemperatur zu verstehen.

Besondere Vorteile des erfindungsgemäßen Schichtaufbaus können sich hinsichtlich der Rauheit ergeben. Eine Rauheit der Oberfläche der Diamantschicht ist in vielen Fällen schon deshalb nicht vermeidbar, weil im Bereich des Interface zwischen dem Substrat und der Diamantschicht eine gewisse Rauheit benötigt wird, die zur Verklammerung führt und eine bessere Haftung ermöglicht. Eine große Rauheit der äußeren Oberfläche der Diamantschicht kann allerdings zu erhöhter Reibung und schlechter Oberflächengüte von bearbeiteten Werkstücken führen. Durch die Hartstoffschicht kann eine verringerte Rauheit direkt nach der Herstellung oder zumindest im Einsatz erzielt werden, wenn die Hartstoffschicht die Rauheit der Diamantschicht ausgleicht. Im Einsatz ist günstig, dass Hartstoffschichten, die weniger hart sind als Diamant, an eventuell bestehenden Rauheitsspitzen der Diamantschicht schneller verschleißen, hingegen in Rauheitstälern eher erhalten bleiben. Somit kann die Hartstoffschicht eine Nivellierung der Oberfläche der Diamantschicht bewirken.

Eine verringerte Rauheit der Oberfläche hat insbesondere für die Funktionsfläche von Werkzeugen eine Bedeutung. Bei der spanabhebenden Bearbeitung von Werkstoffen durch Werkzeuge, bspw. Bohrer, Fräser, etc., wird durch eine glattere Oberfläche die Geräuschentwicklung stark reduziert. So kann es bspw. bei der Bearbeitung von Faserwerkstoffen mittels eines Bohrers mit rauher, diamantbeschichteter Schneide zu Geräuschbildung in Form lauten Quietschens kommen. Bei einem erfindungsgemäßen Bohrer mit einer äußeren Hartstoffschicht kann die Geräuschentwicklung deutlich reduziert werden.

Für die Nivellierung eventueller Rauheiten der Diamantschicht kann es bevorzugt sein, wenn die Dicke der Hartstoffschicht gewählt wird in Abhängigkeit von der Rauheit der Diamantschicht, gemessen in Form der gemittelten Rautiefe R_{z}. Bspw. kann die Dicke der Hartstoffschicht gewählt werden zwischen der Hälfte der Rauheit R_{z} der Diamantschicht und dem Doppelten der Rauheit R_{z} der Diamantschicht.

Die Eigenschaften der äußeren Oberfläche des hergestellten Körpers können auch verbessert werden durch eher weiche Hartstoffschichten, bspw. aus Materialien wie metalldotiertem DLC oder Schmierschichten wie MoS₂, die die Gleiteigenschaften verbessern und Rauheitstäler auffüllen können, die dann als Reservoir für eine Schmierschicht wirken. Entsprechende Werkzeuge sind insbesondere für die Trockenbearbeitung vorteilhaft. In Fällen, in denen die thermische Stabilität der genannten Schmierschichten nicht ausreicht, sind Schichtmaterialien wie Ti-C-N oder Ti-Al-C-N besser geeignet.

Ein weiterer möglicher Vorteil der Kombination der verschiedenen Schichten kann durch die unterschiedlichen Schichtspannungen erzielt werden. Generell weisen Diamantschichten, die mit CVD-Verfahren auf Werkzeugsubstraten erzeugt werden, Druckspannungen auf, die vorwiegend aus unterschiedlichen Wärmeausdehnungskoeffizienten des Diamantmaterials und des Substratmaterials resultieren. Hartstoffschichten, die durch PVD-Verfahren, insbesondere Sputter-Verfahren erzielt werden, weisen ebenfalls Druckspannungen auf, die durch das Ionenbombardement beim Aufbringen der Beschichtungen entstehen. Bei geeigneter Wahl der Beschichtungstemperaturen und aufeinander abgestimmten Materialien sowie Dicken können Konstellationen erreicht werden, bei denen durch die Hartstoffschicht die resultierenden Spannungen in der Diamantschicht reduziert werden können.

Das erfindungsgemäße Schichtsystem aus zwei sehr unterschiedlichen Schichten kann zudem vorteilhaft zur Verschleißerkennung eingesetzt werden. Insbesondere helle und farbintensive Hartstoffschichten, bspw. Ti-N oder Cr-N, können sich beim Einsatz als Werkzeug deutlich von dem meist dunklen und im Verschleißfall teilweise graphitisierten Diamantmaterial abheben und dessen Verschleiß so gut sichtbar machen.

Erfindungsgemäß ausgebildete Werkzeuge können insbesondere zum Schneiden und Zerspanen eingesetzt werden. Besondere Vorteile ergeben sich beim Zerspanen z.B. von Verbundstoffen, bevorzugt von faserverstärkten Verbundstoffen, wo besonders Schichten aus Ti-Si-N, Ti-B und Mehrlagenschichten mit Lagen aus Ti-Al-N und Ti-Si-N von Vorteil sind. Auch beim Schneiden, bevorzugt Zerspanen von Aluminium-Silizium-Legierungen erweisen sich Werkzeuge mit dem erfindungsgemäßen Aufbau als günstig, insbesondere wenn sie Ti-B als Schicht enthalten. Weitere Anwendungen sind bspw. Schneidwerkzeuge zum Zerspanen von Stahl oder eisenhaltiger Gusslegierung oder Schneidwerkzeuge zur Trockenzerspanung.

Gemäß einer Weiterbildung der Erfindung kann die Diamantschicht mindestens eine Lage aufweisen, die mindestens überwiegend, d. h. zu mehr als 50% des Schichtvolumens, bevorzugt zu mehr als 80% des Schichtvolumens, aus nanokristallinem Diamant einer Korngröße von 100 nm oder weniger besteht. Die Diamantschicht kann bspw. vollständig aus einer Lage nanokristallinen Diamants bestehen, oder es können mehrere Lagen aus Diamant vorgesehen sein, wobei sich das Material der Lagen bspw. hinsichtlich der Korngröße und/oder des Volumenanteils von Diamantkristallen am Schichtvolumen unterscheidet.

Nanokristalliner Diamant einer Korngröße von 100 nm oder weniger, bevorzugt weniger als 50 nm und besonders bevorzugt weniger als 10 nm kann sehr glatte Schichten bilden. Ein Verfahren zur Erzeugung von nanokristallinen Diamantschichten durch einen Wechsel zwischen verschiedenen Betriebszuständen in einem CVD-Verfahren ist bspw. angegeben in der WO 2004/083484 A1.

Die Diamantschicht kann auch mindestens eine Lage aufweisen, die zumindest überwiegend aus Diamant einer Korngröße von mehr als 100 nm besteht. Eine derartige Diamantschicht bzw. Lage innerhalb einer mehrlagigen Diamantschicht wird - in Abgrenzung von nanokristallinem Diamant - hier vereinfachend als mikrokristalliner Diamant bezeichnet. Bevorzugt weist eine derartige Diamantschicht bzw. Diamantlage aus mikrokristallinem Diamant eine Korngröße von mehr als 500 nm auf, weiter bevorzugt eine Korngröße von einem Mikrometer oder mehr.

Besonders bevorzugt sind mehrlagige Diamantschichten, insbesondere solche, die sowohl mindestens eine Lage überwiegend aus nanokristallinem Diamant und eine Lage überwiegend aus mikrokristallinem Diamant umfassen. In diesem Fall unterscheiden sich die beiden Lagen sowohl hinsichtlich der Korngröße als auch hinsichtlich des Volumenanteils an Diamantkristallen. Denn bei geringerer Korngröße, und besonders bei nanokristallinem Diamant, ergibt sich gesehen auf den Volumenanteil ein erhöhter Anteil der Korngrenzen. Daher enthält eine vollständig aus nanokristallinem Diamant bestehende Schicht einen höheren Kohlenstoffanteil, der nicht in sp3-Bindung vorliegt. Nanokristalline Schichten weisen zudem eine geringere Rauheit auf, während mikrokristalline Schichten über eine bessere Wärmeleitfähigkeit verfügen. Eine Multilayer-Schicht mit Lagen in nanokristalliner Struktur und Lagen in mikrokristalliner Struktur führt zu einer geringeren Rissausbreitung.

Es sind mehrlagige Diamantschichten bevorzugt, die bspw. 2 - 12 Lagen umfassen.

Mehrlagige Diamantschichten, bei denen sich die Lagen durch verschiedene Parameter wie die Korngröße und dem Diamantanteil voneinander unterscheiden, sind offenbart in der WO 00/60137 der Anmelderin.

Bei der mehrlagigen Diamantschicht kann eine Lage, bevorzugt jede Einzellage innerhalb der Diamantschicht eine Dicke von bspw. 1-5 µm aufweisen. Bevorzugt sind mehrlagige Strukturen, bei denen jede Lage eine Dicke im Bereich von 0,25- 2,5 µm aufweist. Besonders bevorzugt sind Strukturen mit sehr dünnen Lagen im Bereich von 0,5- 1,5 µm.

Innerhalb einer mehrlagigen Diamantschicht können verschiedenste Folgen von Lagen gebildet werden. Bevorzugt ist eine Struktur, bei der zwei Arten von Lagen mehrfach aufeinander folgend abwechselnd angeordnet sind, also bspw. ein erster Typ einer Lage A überwiegend aus nanokristallinem Diamant und ein zweiter Typ einer Lage Baus mikrokristallinem Diamant in einer abwechselnden Struktur der Form A B A B....

In einer Schichtstruktur der Diamantschicht mit verschiedenen Lagen ist es bevorzugt, dass die jeweils äußerste Lage der Diamantschicht überwiegend aus nanokristallinem Diamant besteht. Hierdurch wird eine besonders glatte Schichtoberfläche erzielt. Hingegen ist es bevorzugt, dass die innerste Lage der Diamantschicht, die in Kontakt steht mit dem Substrat oder der Zwischenschicht, zumindest überwiegend aus mikrokristallinem Diamant besteht. Für eine mikrokristalline Lage der Diamantschicht hat sich eine bessere Haftung gezeigt. Insbesondere ist bevorzugt, dass die innerste Lage der Diamantschicht eine Dicke von 3 µm oder weniger aufweist, besonders bevorzugt noch geringer, bspw. 2 µm oder weniger, oder sogar 1,2 µm oder weniger.

In einer bevorzugten Ausführung ist die Diamantschicht elektrisch nichtleitend. Dies ist der Fall für eine undotierte Diamantschicht oder für sehr geringe Dotierung, bspw. mit weniger als 0,05 at-% Bor.

Die Hartstoffschicht kann direkt auf der Diamantschicht abgeschieden werden, bevorzugt in einem PVD-Verfahren, besonders bevorzugt per Magnetronsputtern.

Neben der bei dem erfindungsgemäßen beschichteten Körper vorgesehenen Haftschicht kann zwischen der Diamantschicht und der Hartstoffschicht auch eine Übergangsschicht vorgesehen sein. Die Haftschicht oder die Übergangsschicht können dabei direkt mit der Diamantschicht und/oder der Hartstoffschicht in Kontakt stehen, unterscheiden sich aber in ihrer Struktur und/oder Zusammensetzung von der Hartstoffschicht und/oder der Diamantschicht. Insbesondere kann die Haftschicht einen geringeren Anteil an Hartstoffverbindungen aufweisen als die Übergangsschicht und/oder als die Hartstoffschicht.

Eine Haftschicht, die Kohlenstoff und mindestens ein metallisches Element umfasst, ist bei dem erfindungsgemäßen beschichteten Körper zwischen der Diamantschicht und der Hartstoffschicht vorgesehen. Insbesondere kann die Haftschicht unmittelbar an die Diamantschicht angrenzen. Ein oder mehrere metallische Elemente ausgewählt aus der Gruppe Ti und Cr sind in der Haftschicht vorgesehen.

Mindestens ein metallisches Element der Haftschicht kann bevorzugt auch ein Element der Hartstoffschicht oder der Übergangsschicht sein.

Die Haftschicht ist bei dem erfindungsgemäßen Verfahren gebildet durch Implantation von Metallatomen in einer äußeren Zone der Diamantschicht. Dies erfolgt bei dem erfindungsgemäßen Verfahren durch ein HIPIMS-Ätzverfahren, bei dem Metallionen in die Oberfläche der Diamantschicht implantiert werden.

Die Haftschicht kann bspw. mindestens die Elemente Ti und C aufweisen. Besonders bevorzugt ist eine Haftschicht, die Ti, Cr oder beide Elemente enthält und direkt auf der Diamantschicht gebildet ist. Dabei ist bevorzugt, dass die Haftschicht überwiegend, d.h. zu mehr als 50 at-%, bevorzugt mehr als 90 at-% Ti und C aufweist, besonders bevorzugt aus Ti und C besteht. Dabei ist weiter bevorzugt, dass die Haftschicht die Hartstoffverbindung TiC enthält.

Die Haftschicht weist bei dem erfindungsgemäßen beschichteten Körper eine Dicke von 2 - 80 nm auf, bevorzugt 5 - 40 nm. Es ist bevorzugt, dass die Konzentration mindestens eines metallischen Elements, bevorzugt aller metallischen Elemente in der Haftschicht einen mit dem Abstand vom Substrat ansteigenden Gradienten aufweisen, also der Metallanteil nach Außen hin zunimmt. Beispielsweise sind Haftschichten bevorzugt, bei denen die Konzentration von Ti und/oder Cr einen mit dem Abstand vom Substrat ansteigenden Gradienten aufweist, also bei denen unmittelbar in Kontakt mit der Diamantschicht zunächst eine im Vergleich geringere Konzentration von Ti und/oder Cr vorhanden ist, die dann bevorzugt stetig ansteigt. So wird ein guter Übergang zwischen der Diamantschicht und der Hartstoffschicht oder der Übergangsschicht geschaffen, insbesondere im Fall einer Hartstoffschicht oder Übergangsschicht, die ihrerseits Ti und/oder Cr als Bestandteile aufweist.

Durch eine Haftschicht kann eine gute Verankerung in der Diamantschicht erreicht werden.

So wird der Übergang zur Hartstoffschicht oder einer Übergangsschicht verbessert. Zudem wird die Diamantschicht durch das Einbringen von metallischen Elementen leitfähig, so dass nachfolgende Sputterverfahren problemlos angewendet werden können. Die Außenseite der Haftschicht wird bevorzugt überwiegend durch eine Hartstoffverbindung gebildet, bspw. TiC oder Cr₃C₂.

Eine Übergangsschicht zwischen der Diamantschicht und der Hartstoffschicht, oder zwischen der Haftschicht und der Hartstoffschicht kann bspw. mindestens ein metallisches Element und ein nichtmetallisches Element enthalten. Dabei unterscheidet sich die Übergangsschicht bevorzugt in der Zusammensetzung von der Hartstoffschicht.

Die Übergangsschicht kann bspw. mindestens eines, bevorzugt mehrere der Elemente Si, V, W, Ti, Cr, C oder N enthalten. Bevorzugt enthält sie C und/oder N als nichtmetallische Elemente und Ti und/oder Cr als metallische Elemente. Besonders bevorzugt ist eine Übergangsschicht, die Ti als eines der metallischen Elemente oder als einziges metallisches Element enthält.

Bspw. kann die Übergangsschicht Ti-N, Ti-C, Ti-C-N, Cr-C, Cr-C-N oder Cr-N enthalten bzw. überwiegend oder vollständig hieraus bestehen. Besonders bevorzugt ist Ti-C. Diese Materialsysteme haben sich als besonders geeignet erwiesen, um einen guten Übergang von der Diamantschicht oder Haftschicht zur Hartstoffschicht zu erreichen. Die Übergangsschicht besteht bevorzugt überwiegend aus Hartstoffverbindungen, bevorzugt zu über 70 vol-%, besonders bevorzugt zu über 90 vol-%. Dabei ist bevorzugt der Anteil von Hartstoffverbindungen in der Übergangsschicht höher als in der Haftschicht.

Eine Übergangsschicht kann bspw. eine Dicke von 0,1 - 2 µm, bevorzugt von 0,5 - 1,5 µm aufweisen.

In bevorzugten Ausführungsformen kann die Dicke der Übergangsschicht oder der Haftschicht, oder der Summe der Dicken von Haft- und Übergangsschicht in Abhängigkeit von der Rauheit der Diamantschicht gewählt werden. Bevorzugt kann diese Dicke kleiner sein als der Wert der Oberflächenrauheit Rz der Diamantschicht. So können Scherebenen in den Schichten insbesondere während des Einsatzes als Werkzeug, bspw. zur Zerspanung, vermieden werden.

Die Struktur und Zusammensetzung der Übergangsschicht kann über die Dicke konstant und homogen sein. Es ist aber bevorzugt, dass die Zusammensetzung über die Dicke variiert. Bevorzugt kann die Konzentration von nichtmetallischen Elementen in der Übergangsschicht variieren. Dabei ist es bevorzugt, dass näher an der Diamantschicht die Konzentration von Kohlenstoff höher ist, während näher an der Hartstoffschicht die Konzentration von Nichtmetallelementen der Hartstoffschicht höher ist. Ferner kann die Konzentration von nichtmetallischen Elementen in der Übergangsschicht so variieren, dass sie sich über einen Teil der Dicke oder über die gesamte Schichtdicke der Übergangsschicht kontinuierlich verändert, indem sich bspw. zwischen einer TiC-Lage und einer TiN-Lage eine gradierte TiCN-Lage befindet.

Die Übergangsschicht kann mindestens eine Lage aufweisen, die Kohlenstoff, Stickstoff und mindestens ein metallisches Element umfasst. Insbesondere kann die Übergangsschicht eine erste Lage mit Kohlenstoff, Stickstoff und einem oder mehreren metallischen Elementen und eine weiter vom Substrat entfernte zweite Lage aus einem Nitrid des oder der metallischen Elemente umfassen. Dabei sind Übergangsschichten bevorzugt, die Ti als einziges metallisches Element aufweisen (bspw. Ti-C, bevorzugt Ti-C-N oder Ti-N), oder die Cr als einziges metallisches Element aufweisen (bspw. Chromcarbid, insbesondere Cr₂C₃, Cr-C-N oder Cr-N), oder die sowohl Ti als auch Cr als metallische Elemente aufweisen.

Die Haftschicht ist gebildet durch in die Diamantschicht im äußeren Bereich implantierte und/oder eindiffundierte Atome von einem oder mehreren metallischen Elementen der Hartstoffschicht oder Übergangsschicht, bspw. von mindestens einem der Elemente Cr, Al und Ti, besonders bevorzugt Ti. Eine Implantation und Anregung von Atomen ist insbesondere möglich durch eine Ionen-Vorbehandlung mit ausreichender Bias-Spannung, durch die ionisierte Atome auf die Diamantschicht als Substrat hin beschleunigt und dort implantiert werden und/oder eindiffundieren. Durch die Implantation und/oder Diffusion ergibt sich eine besonders vorteilhafte Haftschicht als Interface-Bereich zwischen der Diamantschicht und der Hartstoffschicht oder zwischen der Diamantschicht und einer Übergangsschicht. Bzgl. des Verfahrens ist es bevorzugt, dass vor Aufbringen der Hartstoffschicht oder Übergangsschicht die Oberfläche der Diamantschicht mittels HIPIMS-Metallionenätzung vorbehandelt wird. Hierdurch kann ein besonders inniger Schichtverbund mit guten mechanischen Eigenschaften und guter Schichthaftung erzielt werden. Eine HIPIMS-Metallionenätzung erlaubt insbesondere eine günstige Implantation, Diffusion und Aktivierung der Ionen im oberflächennahen Bereich der Diamantschicht, so dass die Bildung einer Haftschicht möglich ist. Dabei kann beim Metallionenätzen eine oder mehrere Magnetron-Kathoden als HIPIMS-Elektrode betrieben werden. HIPIMS (HIgh Power Impulse Magnetron Sputtering), auch HPPMS (High Power Pulsed Magnetron Sputtering) sieht den Betrieb mindestens einer Magnetron-Kathode mit sehr kurzen, sehr energiereichen Pulsen vor, wodurch eine hohe Ionisationsdichte erzielt wird. Charakteristisch für den HIPIMS-Betrieb ist ein geringes Verhältnis zwischen der Pulsdauer und der Pulspause von unter 0,1, d. h., dass die Pulspause mehr als 10-mal so lang ist wie die Pulsdauer. Vorrichtungen und Verfahren zum Betrieb von Magentron-Kathoden per HIPIMS sind bspw. offenbart in der WO 2009/132822 A2 der Anmelderin.

Durch die Implantation und/oder Eindiffusion von Ionen in die Diamantschicht und/oder das Zerstäuben der Diamantschicht können Metallcarbide gebildet werden. Bspw. bei Ti-Ionen reagiert Titan zu Titancarbid (TiC) und es ergibt sich eine gradierte Haftschicht.

Damit es auf nichtleitenden Diamantschichten nicht zu Aufladungen oder Bogenentladungen kommt, ist eine sorgfältige Auswahl der Bias-Spannung beim Ionenätzen ebenso wie bei der Beschichtung mittels Magnetron-Sputtern sinnvoll. Während bei leitfähigen Schichten eine Bias-Spannung von bspw. 1000V gewählt werden kann, ist bei nichtleitenden Diamantschichten zumindest zu Beginn der Behandlung eine geringere Bias-Spannung von bspw. 200 - 400V, bevorzugt 250 - 350 Volt empfehlenswert. Die genannten BiasSpannungen sind so zu verstehen, dass der negative Pol am Substrat liegt. Nach Bildung einer leitfähigen Haftschicht kann Magnetronsputtern wie bei leitfähigen Substraten fortgeführt werden kann. Eine Dotierung der Diamantschicht bspw. mit Bor, mit der eine elektrische Leitfähigkeit erzielt werden kann, ist somit nicht notwendig. So wird der Aufwand verringert und auch eine Kontamination der Beschichtungsanlage mit Bor sowie Einflüsse von Bor auf die Diamantschicht vermieden.

In einer Ausführungsform kann auf der Diamantschicht durch Zugabe eines kohlenstoffhaltigen Reaktivgases reaktiv eine Karbidschicht, bspw. TiC-Schicht als eine erste Lage einer Übergangsschicht erzeugt werden. Anschließend kann durch Wechsel auf ein stickstoffhaltiges Reaktivgas eine Nitridschicht, bspw. TiN-Schicht als zweite Lage einer Übergangsschicht abgeschieden werden. Auch hier ist ein gradierter Übergang von einer Karbidlage auf eine Nitridlage über eine Karbonitrid-Zwischenlage bevorzugt, bspw. von Ti-C auf Ti-N über eine Ti-C-N-Zwischenlage. Auf die so gebildete Übergangsschicht mit äußerer Nitrid-Lage, insbesondere Ti-N, kann nahezu jede der genannten Hartstoffschichten aufgebracht werden, im Besonderen nitridische Schichten wie Ti-Al-N.

Alternativ zur Verwendung von Ti kann auch Cr verwendet werden. Dann können, ebenso wie oben beispielhaft für Ti beschrieben, bspw. zunächst Cr-Ionen in die Diamantschicht implantiert werden und/oder eindiffundieren. Dies ist bspw. bei einer Cr-haltigen Hartstoffschicht sinnvoll. Auch Kombinationen mit Ti und Cr sind möglich. Es können auch Metalle wie Ti, W, Ta einzeln oder in Kombination verwendet werden.

Besonders bevorzugt kann die Hartstoffschicht mittels Magnetron-Sputtern aufgebracht werden, wobei bevorzugt mindestens eine Magentron-Kathode nach dem HIPIMS-Verfahren betrieben wird. Dabei kann die Hartstoffschicht ausschließlich mit einer oder mehreren HIPIMS-Kathoden erzeugt werden, oder die HIPIMS-Kathode wird gemeinsam mit anderen Kathoden, bspw. UBM-Kathoden im DC-Betrieb verwendet, um die Hartstoffschicht aufzubringen.

Das HIPIMS-Verfahren kann auch verwendet werden, um eine Zwischenschicht zwischen den Substrat und der Diamantschicht zu erzeugen. Auch hier kann die Zwischenschicht vollständig durch HIPIMS-Beschichten und/oder durch Simultanbetrieb mindestens einer HIPIMS-Kathode mit weiteren Kathoden erzeugt werden. Alternativ oder zusätzlich kann vor dem Aufbringen der Zwischenschicht das Substrat mittels Ionenätzen vorbehandelt werden, wobei die Ionen durch mindestens eine Magnetron-Kathode erzeugt werden, die nach dem HIPIMS-Verfahren betrieben wird.

Sowohl die Vorbehandlung der Diamantschicht durch HIPIMS-Metallionenätzung als auch die anschließende Erzeugung der Hartstoffschicht oder vorherige Erzeugung einer Zwischenschicht kann bevorzugt in einer Mehrkathoden-Magnetronsputteranlage, insbesondere mit mehreren unbalancierten Magnetrons erfolgen, die sich einzeln selektiv konventionell oder mittels HIPIMS betreiben lassen. So kann die erfindungsgemäße Erzeugung der Haftschicht mittels HIPIMS-Metallionenätzung erfolgen, indem mindestens eine Magnetron-Kathode in der HIPIMS-Betriebsart betrieben wird. Dabei ist es möglich, dass kein oder nur ein geringes Schichtwachstum stattfinden, wobei die Erzeugung der Haftschicht durch eine Umwandlung der obersten Zone der Diamantschicht erfolgt. Die Vorbehandlung führt zu einem Aktivieren der Diamantoberfläche, zu einer Implantation oder Eindiffusion von Metallatomen, sowie zur Bildung von Metallcarbiden. Dabei kann die Diamantschicht zu einem kleinen Anteil auch selbst zerstäubt werden. Andererseits können auch kohlenstoffhaltige Gase wie CH4 oder C2H2 zusätzlich zugeführt werden.

Auch bei der anschließenden Erzeugung der Hartstoffschicht oder einer Zwischenschicht kann mindestens eine Magnetron-Kathode in der HIPIMS-Betriebsart betrieben werden. Im Gegensatz zur Vorbehandlung durch Metallionenätzung werden dabei höhere Schichtraten angestrebt. Dazu werden bevorzugt neben Reaktivgasen auch Inertgase wie Argon und Krypton eingeleitet.

In Mehrkathoden-Magnetronsputteranlagen können die einzelnen Kathoden auch im Mischbetrieb z.T. konventionell und z.T. in HIPIMS-Betriebsart betrieben werden.

Im Vergleich zu Arc-basierten PVD-Verfahren, wie bspw. "Arc Ion Plating" (AiP) entstehen beim Sputter-Verfahren hier keine Droplets in den Schichten. Es findet jedoch ein geringer Einbau von Sputtergasen in die Schicht statt. Der Inertgasanteil in der Schicht kann bspw. in der Regel zwischen 0,1 und 0,5 Atomprozent liegen.

Eine Reduktion des Inertgasanteils in einer im HIPIMS-Verfahren erzeugten Hartstoffschicht kann bspw. durch eine Erhöhung der Anzahl oder der Leistung der HIPIMS-Kathoden erfolgen. Bevorzugt kann eine Reduktion erzielt werden, indem während der Beschichtung keine konstante Bias-Spannung am Substrat angelegt wird, sondern eine gepulste Bias-Spannung, die bevorzugt mit den HIPIMS-Pulsen synchronisierte Bias-Pulse aufweist. Ein HIPIMS-Verfahren mit derartigen synchronisierten Bias-Pulsen ist in der WO 2014/154894 A1 beschrieben, worauf hier ausdrücklich Bezug genommen wird. Insbesondere durch synchrone, aber zeitlich zu den HIPIMS-Pulsen versetzte Bias-Pulse, mit denen eine Bias-Spannung anliegt zu den Zeiten, in denen die Metallionendichte während der HIPIMS-Pulse besonders hoch ist, kann der Inertgasanteil in der Schicht auf bspw. 0,01-0,1 Atomprozent reduziert werden. Die Hartstoffschicht kann so bspw. je nach Art der Herstellung einen Inertgasanteil 0,01 bis 0,5 Atomprozent aufweisen.

Typische Werte für die HIPIMS Parameter sind gemittelte Leistungen von bspw. 2,27 bis 22,7 W/cm² der Targetfläche, also bspw. je Target mit jeweils einer Fläche von bspw. 440 cm² eine Leistung von 1000 - 10.000 W. Die im HIPIMS-Verfahren bevorzugt verwendeten Pulsdauern können bspw. 10-200 µs betragen. Die HIPIMS-Pulse können bevorzugt mit Frequenzen von bspw. 100 - 10.000 Hz erzeugt werden. Bevorzugte Werte für den Druck in einer Beschichtungskammer können bspw. bei 100 - 1000 mPa liegen.

Im bevorzugten Fall der Verwendung synchronisierter Bias-Pulse wird bei HIPIMS-Frequenzen oberhalb 1000 Hz für die Bias-Pulse die gleiche Frequenz gewählt; unterhalb von 1000 Hz und bei einer Anzahl von N zeitlich versetzt betriebenen HIPIMS-Kathoden ist für die Bias-Pulse die N-fache Frequenz bevorzugt. Der Offset für die Biaspulse zum effektiveren Einfangen der Metallionen kann bspw. 10-120 µs betragen bei Pulslängen von maximal 200 µs. Die Biasspannungen können bspw. 10-1200 V betragen.

Als Zwischenschicht zwischen dem Substrat und der Diamantschicht ist eine metallische Zwischenschicht bevorzugt. Diese kann besonders bevorzugt zumindest überwiegend aus Atomen der Elemente Cr, W und/oder Ti bestehen. Beispiele hierzu sind offenbart in der WO2011/135100 der Anmelderin, die diesbezüglich hiermit ausdrücklich einbezogen wird.

Nachfolgend werden Ausführungsformen der Erfindung anhand von Zeichnungen näher beschrieben. Dabei zeigen:
- Fig. 1: in Seitenansicht ein beschichtetes Werkzeug gemäß einer Ausführungsform der Erfindung;
- Fig. 2: in schematischer Darstellung einen Querschnitt durch eine Schichtstruktur entsprechend einer ersten Ausführungsform;
- Fig. 3: in schematischer Darstellung einen Querschnitt durch eine Schichtstruktur entsprechend einer zweiten Ausführungsform.

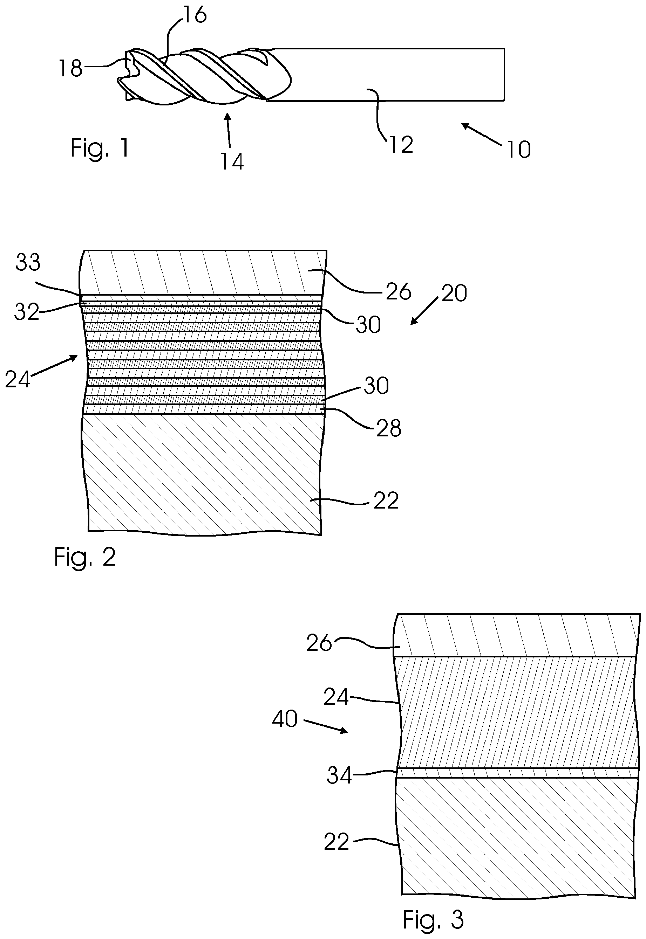

Fig. 1 zeigt in Seitenansicht einen Schaftfräser 10 mit einem Schaft 12 und einer Schneide 14. Die Schneide 14 umfasst Hauptschneiden 16 und Nebenschneiden 18. Beide bilden Funktionsflächen des Werkzeugs 10.

Im Ausführungsbeispiel besteht der Körper des Fräsers 10 aus Hartmetall, d.h. gesinterten Wolframcarbid-Körnern in einer Cobalt-Matrix. Mindestens die Schneide 14 ist mit einer Beschichtung mit einem Schichtaufbau versehen, der nachstehend erläutert wird.

In Fig. 2 ist schematisch ein Querschnitt durch einen Schichtaufbau gemäß einer ersten Ausführungsform 20 dargestellt. Im unteren Bereich befindet sich nur teilweise dargestellt das Hartmetall-Substrat 22. Im gezeigten Beispiel unmittelbar darauf angeordnet ist eine Diamantschicht 24. Oberhalb der Diamantschicht 24 ist eine Hartstoffschicht 26 gebildet.

Die Diamantschicht 24 ist im gezeigten Beispiel eine mehrlagige Diamantschicht mit abwechselnd angeordneten Lagen aus mikrokristallinem Diamant 28 und aus nanokristallinem Diamant 30. Unmittelbar auf dem Substrat 22 ist eine erste Lage 28 aus mikrokristallinem Diamant angeordnet, darüber eine Lage 30 aus nanokristallinem Diamant usw. Die äußerste Lage 30 der Diamantschicht 24 ist eine nanokristalline Lage.

Die Hartstoffschicht 26 ist oberhalb der Diamantschicht 24 angeordnet, wobei zwischen den Schichten eine Haftschicht 32 und einer Übergangsschicht 33 gebildet sind.

Die Hartstoffschicht 26 ist im gezeigten Beispiel eine einlagige Al-Ti-Cr-N-Schicht.

Die Haftschicht 32 ist in dem Beispiel als Ti-C-Schicht gebildet, wobei Ti-Atome durch HIPIMS-Ätzen in der Oberfläche der Diamantschicht 24 implantiert und/oder eindiffundiert sind.

Die Übergangsschicht 33 weist (nicht dargestellt) eine innere Hartstofflage aus reaktiv abgeschiedenem TiC, eine äußere Lage aus reaktiv abgeschiedenem TiN und dazwischen eine Übergangszone aus TiCN auf.

Das Werkzeug 10 mit der Beschichtung auf der Schneide 14 gemäß dem dargestellten Schichtaufbau 20 erweist sich als besonders geeignet zum Zerspanen von faserverstärkten Verbundstoffen, von Aluminium-Silizium-Legierungen und von stahl- oder eisenhaltiger Gusslegierung. Die Al-Ti-Cr-N-Hartstoffschicht 26 ist dabei mit der Diamantschicht 24 fest verankert. Durch die Hartstoffschicht 26 ist die harte Diamantschicht 24 von einem unmittelbaren Kontakt mit dem jeweils bearbeiteten Werkstoff isoliert, so dass chemischer Verschleiß minimiert ist. Eine verbleibende Rauheit der Diamantschicht 24 wird durch die Hartstoffschicht 26 nivelliert. Bei der Bearbeitung der genannten Werkstoffe bleibt die thermische Belastung begrenzt durch die gute Wärmeleitfähigkeit der Diamantschicht 24. Zur Herstellung des Werkzeugs 10 wird auf dem Hartmetall-Substrat 22 nach ausreichender Vorbehandlung erst die Diamantschicht 24 in einem Hot-Filament-CVD-Verfahren aufgebracht, wie bspw. beschrieben in der WO 00/60137. Die nanokristallinen Lagen 30 können dabei mit einem Verfahren gemäß der WO 2004/083484 A1 erzeugt werden.

Oberhalb der Diamantschicht 24 wird anschließend die Haftschicht 32 auf der Oberfläche der Diamantschicht 24 gebildet. Dies erfolgt innerhalb einer PVD-Anlage. Nach dem Aufheizen der Substrate und einem Ionenätzen mit Ar-Ionen mit Pulsen im Mittelfrequenzbereich erfolgt zunächst eine Behandlung der Oberfläche der Diamantschicht 24 durch ein Ionenätzen mit per HIPIMS erzeugten Ti-Ionen, bspw. in einer Anlage gemäß WO 2009/132822 A2. Hierbei werden Ti-Ionen, die aus einem Ti-Target einer per HIPIMS betriebenen Magnetron-Kathode erzeugt werden, durch eine Bias-Spannung von ca. 300 V auf das Werkzeug 10 hin beschleunigt und so in die Oberfläche der Diamantschicht 24 eingebracht.

Nach ca. 30 Minuten hat sich eine ca. 20 nm dicke, leitfähige Haftschicht aus Ti-C gebildet. Diese Bildung kann durch Eindiffundieren der energiereichen und sehr reaktiven Ti-Ionen oder Atome erfolgen und /oder auch durch Implantation der Ti-Ionen. Die Reaktion kann ferner durch gesputterte und angeregte Kohlenstoffatome des Materials der Diamantschicht 24 begünstigt werden. Analyse mit XPS hat ergeben, dass die Ti-C Haftschicht die Hartstoffverbindung TiC enthält. Durch diese Behandlung wird die zuvor als undotierte Diamantschicht elektrisch nicht leitfähige Oberfläche elektrisch leitfähig und kann einfacher mit weiteren Sputterverfahren behandelt werden.

Durch die Zugabe von Argon als Prozessgas sowie ein kohlenstoffhaltiges Reaktivgas, bspw. C₂H₂, sowie durch Reduktion der Bias-Spannung, erfolgt die Bildung einer Übergangsschicht 33, indem zunächst eine TiC-Schicht abgeschieden wird.

Nachfolgend wird die Zuführung des kohlenstoffhaltigen Gases kontinuierlich verringert, während in ansteigendem Maße Stickstoff als Reaktivgas zugeführt wird. So wird eine äußere TiN Lage und zwischen der inneren und äußeren Lage der Übergangsschicht 33 TiCN gebildet. Innerhalb der Übergangsschicht 33 weisen somit beide nichtmetallische Elemente N, C eine in Dickenrichtung variierende Konzentration auf, wobei in Richtung vom Substrat aufwärts der Kohlenstoffanteil stetig geringer wird während der Stickstoffanteil stetig ansteigt.

Anschließend wird auf die Haftschicht 32 die Al-Ti-Cr-N Hartstoffschicht 26 mittels reaktiven Magnetron-Sputterns unter Zuführung von Stickstoff aufgebracht.

Fig. 3 zeigt schematisch einen Schichtaufbau 40 gemäß einer zweiten Ausführungsform. Dieser umfasst wie der Schichtaufbau 20 gemäß der ersten Ausführungsform eine Diamantschicht 24 oberhalb des Substrats 22 und eine Hartstoffschicht 26 oberhalb der Diamantschicht 24.

Die Struktur der Diamantschicht 24 ist hier im Unterschied zur ersten Ausführungsform einlagig. Zwischen der Diamantschicht 24 und der Hartstoffschicht 26 ist eine Haftschicht 32 (nicht dargestellt), aber keine Übergangsschicht 33 vorgesehen.

Der Schichtaufbau 40 gemäß der zweiten Ausführungsform unterscheidet sich vom Schichtaufbau 20 gemäß der ersten Ausführungsform weiter durch eine Zwischenschicht 34, die auf der Oberfläche des Substrats 22 gebildet und zwischen dem Substrat 22 und der Diamantschicht 24 angeordnet ist. Bei der Zwischenschicht 34 handelt es sich um eine vorwiegend metallische Zwischenschicht aus Cr.

Bei der Herstellung des Schichtaufbaus 40 gemäß Fig. 3 erfolgt zunächst die Erzeugung der Zwischenschicht 34 in einem Magnetron-Sputter Verfahren mit mindestens einem Cr-Target. Anschließend wird auf die so gebildete Zwischenschicht 34, wie schon für den Schichtaufbau 20 beschrieben, zunächst die Diamantschicht 24 und anschließend die Haftschicht 32 und die Hartstoffschicht 26 aufgebracht.

## Patentansprüche

1. Beschichteter Körper, mindestens umfassend
- ein Substrat (22),
- mindestens eine Diamantschicht (24) einer Dicke von 1 - 40 µm,
- und mindestens eine Hartstoffschicht (26), die sich zusammensetzt aus einem oder mehreren metallischen Elementen und einem oder mehreren nichtmetallischen Elementen,
- wobei das metallische Element, oder die metallischen Elemente, ausgewählt sind aus der Gruppe umfassend Al, Si und Elemente der Gruppen 4 bis 6 des Periodensystems nach IUPAC (1988),
- und wobei das nichtmetallische Element, oder die nichtmetallischen Elemente, ausgewählt sind aus der Gruppe umfassend B, N und O
- wobei die Hartstoffschicht (26) am Körper (10) weiter außen als die Diamantschicht (24) angeordnet ist,
**gekennzeichnet durch**
- eine Haftschicht (32) einer Dicke von 2 - 80 nm zwischen der Diamantschicht (24) und der Hartstoffschicht (26), die Kohlenstoff und mindestens ein metallisches Element enthält, wobei das metallische Element oder die metallischen Elemente der Haftschicht (32) aus einer Gruppe umfassend Ti und Cr ausgewählt sind,
- wobei die Haftschicht (32) gebildet ist durch Implantation oder Diffusion von Metallatomen in einer äußeren Zone der Diamantschicht (24).

2. Beschichteter Körper nach Anspruch 1, bei dem
- die Konzentration mindestens eines metallischen Elements in der Haftschicht (32) einen mit dem Abstand vom Substrat (22) ansteigenden Gradienten aufweist.

3. Beschichteter Körper nach einem der vorangehenden Ansprüche, bei dem
- das metallische Element oder die metallischen Elemente der Haftschicht (32) ausgewählt sind aus einer Gruppe umfassend Ti und Cr.

4. Beschichteter Körper nach einem der vorangehenden Ansprüche, bei dem
- die Haftschicht (32) überwiegend aus Ti und C besteht.

5. Beschichteter Körper nach einem der vorangehenden Ansprüche, bei dem
- die Haftschicht (32) eines oder mehrere der metallischen Elemente der Hartstoffschicht (26) und/oder einer Übergangsschicht (33) enthält.

6. Beschichteter Körper nach einem der vorangehenden Ansprüche, bei dem
- eine Übergangsschicht (33) zwischen der Diamantschicht (24) und der Hartstoffschicht (26) vorgesehen ist, die mindestens ein metallisches Element und mindestens ein nichtmetallisches Element enthält,
- wobei die Übergangsschicht (33) zwischen der Haftschicht (32) und der Hartstoffschicht (26) vorgesehen ist.

7. Beschichteter Körper nach einem der vorangehenden Ansprüche, bei dem
- die Diamantschicht (24) mindestens eine Lage (30) aufweist, die mindestens überwiegend aus nanokristallinem Diamant einer Korngröße von 100 nm oder weniger besteht.

8. Beschichteter Körper nach einem der vorangehenden Ansprüche, bei dem
- die Diamantschicht (24) mindestens eine Lage (28) aufweist, die mindestens überwiegend aus Diamant einer Korngröße von mehr als 100 nm besteht.

9. Beschichteter Körper nach einem der vorangehenden Ansprüche, bei dem
- die Diamantschicht (24) elektrisch nichtleitend ist und die Haftschicht (32) elektrisch leitend ist

10. Beschichteter Körper nach einem der vorangehenden Ansprüche, bei dem
- die Hartstoffschicht (26) ein- oder mehrlagig ausgebildet ist,
- und mindestens eine Lage aus Ti-Al-N, Ti-N, Ti-C-N, Ti-Al-C-N, Ti-Al-Si-N, Ti-Si-N, Al-Cr-N, Al-Cr-Si-N und/ oder Ti-B besteht.

11. Beschichteter Körper nach einem der vorangehenden Ansprüche, bei dem
- zwischen dem Substrat (22) und der Diamantschicht (24) eine metallische Zwischenschicht (34) vorgesehen ist, die überwiegend aus Atomen der Elemente Cr, W und/ oder Ti besteht.

12. Verfahren zur Beschichtung eines Körpers (10), bei dem
- oberhalb eines Substrats (22) eine Diamantschicht (24) einer Dicke von 1 - 40 µm mittels eines CVD-Verfahrens aufgebracht wird,
- und oberhalb der Diamantschicht (24) mindestens eine Hartstoffschicht (26) mittels eines PVD-Verfahrens aufgebracht wird,
- wobei sich die Hartstoffschicht (26) zusammensetzt aus einem oder mehreren metallischen Elementen und einem oder mehreren nichtmetallischen Elementen,
- wobei das metallische Element, oder die metallischen Elemente, ausgewählt sind aus der Gruppe umfassend Al, Si und Elemente der Gruppen 4 bis 6 des Periodensystems nach IUPAC (1988),
- und wobei das nichtmetallische Element, oder die nichtmetallischen Elemente, ausgewählt sind aus der Gruppe umfassend B, N und O
**dadurch gekennzeichnet, dass**
- eine Haftschicht (32) einer Dicke von 2 - 80 nm, die Kohlenstoff und mindestens ein metallisches Element ausgewählt aus einer Gruppe umfassend Ti und Cr enthält, zwischen der Diamantschicht (24) und der Hartstoffschicht (26) erzeugt wird, indem vor Aufbringen der Hartstoffschicht (26) die Oberfläche der Diamantschicht (24) mittels HIPIMS-Metallionenätzung vorbehandelt wird, wobei Metallionen in die Oberfläche der Diamantschicht (24) implantiert werden und/oder eindiffundieren.

13. Verfahren nach Anspruch 12, bei dem
- die Oberfläche der Diamantschicht (24) bei der HIPIMS-Metallionenätzung mit Ti-Ionen behandelt wird.

## Claims

1. Coated body comprising at least
- a substrate (22),
- at least one diamond layer (24) with a thickness of 1 - 40 µm,
- and at least one hard material layer (26), which is composed of one or more metallic elements and one or more non-metallic elements,
- wherein the metallic element or elements are selected from the group comprising Al, Si and elements of groups 4 to 6 of the periodic table according to IUPAC (1988),
- and wherein the non-metallic element or elements are selected from the group comprising B, N and O
- where the hard material layer (26) is arranged further outside on the body (10) than the diamond layer (24),
**characterized by**
- an adhesive layer (32) having a thickness of 2 - 80 nm between the diamond layer (24) and the hard material layer (26) and containing carbon and at least one metallic element, wherein the metallic element or elements of the adhesive layer (32) are selected from a group comprising Ti and Cr,
- wherein the adhesive layer (32) is formed by implantation or diffusion of metal atoms in an outer zone of the diamond layer (24).

2. Coated body according to claim 1, wherein
- the concentration of at least one metallic element in the adhesive layer (32) has a gradient that increases with the distance from the substrate (22).

3. Coated body according to any of the preceding claims, wherein
- the metallic element or elements of the adhesive layer (32) are selected from a group comprising Ti and Cr.

4. Coated body according to any of the preceding claims, wherein
- the adhesive layer (32) consists predominantly of Ti and C.

5. Coated body according to any of the preceding claims, wherein
- the adhesive layer (32) contains one or more of the metallic elements of the hard material layer (26) and/or a transition layer (33).

6. Coated body according to any of the preceding claims, wherein
- a transition layer (33) is provided between the diamond layer (24) and the hard material layer (26), which contains at least one metallic element and at least one non-metallic element,
- wherein the transition layer (33) is provided between the adhesive layer (32) and the hard material layer (26).

7. Coated body according to any of the preceding claims, wherein
- the diamond layer (24) has at least one layer (30) which consists at least predominantly of nanocrystalline diamond with a grain size of 100 nm or less.

8. Coated body according to any of the preceding claims, wherein
- the diamond layer (24) has at least one layer (28) which consists at least predominantly of diamond with a grain size of more than 100 nm.

9. Coated body according to any of the preceding claims, wherein
- the diamond layer (24) is electrically non-conductive and the adhesive layer (32) is electrically conductive

10. Coated body according to any one of the preceding claims, wherein
- the hard material layer (26) is formed in one or more layers,
- and at least one layer consists of Ti-Al-N, Ti-N, Ti-C-N, Ti-Al-C-N, Ti-Al-Si-N, Ti-Si-N, Al-Cr-N, Al-Cr-Si-N and/or Ti-B.

11. Coated body according to any one of the preceding claims, wherein
- a metallic intermediate layer (34) is provided between the substrate (22) and the diamond layer (24), which consists predominantly of atoms of the elements Cr, W and/or Ti.

12. Method of coating a body (10), in which
- a diamond layer (24) with a thickness of 1 - 40 µm is applied above of a substrate (22) by means of a CVD process,
- and above the diamond layer (24) at least one hard material layer (26) is applied by means of a PVD process,
- wherein the hard material layer (26) is composed of one or more metallic elements and one or more non-metallic elements,
- wherein the metallic element or elements are selected from the group comprising Al, Si and elements of groups 4 to 6 of the periodic table according to IUPAC (1988),
- and wherein the non-metallic element or elements are selected from the group comprising B, N and O
**characterized in that**
- an adhesive layer (32) having a thickness of 2-80 nm and containing carbon and at least one metallic element selected from a group comprising Ti and Cr is formed between the diamond layer (24) and the hard material layer (26) by pretreating the surface of the diamond layer (24) by HIPIMS metal ion etching prior to application of the hard material layer (26), wherein metal ions are implanted and/or diffuse into the surface of the diamond layer (24).

13. Method according to claim 12, wherein
- the surface of the diamond layer (24) is treated with Ti ions during HIPIMS metal ion etching.

## Revendications

1. Corps revêtu comprenant au moins
- un substrat (22),
- au moins une couche de diamant (24) d'une épaisseur de 1 à 40 µm,
- et au moins une couche de matériau dur (26), composée d'un ou plusieurs éléments métalliques et d'un ou plusieurs éléments non métalliques,
- dans lequel le ou les éléments métalliques sont choisis dans le groupe comprenant Al, Si et les éléments des groupes 4 à 6 du tableau périodique selon l'UICPA (1988),
- et dans lequel l'élément ou les éléments non métalliques sont choisis dans le groupe comprenant B, N et O
- la couche de matériau dur (26) est disposée plus à l'extérieur sur le corps (10) que la couche de diamant (24),
**caractérisé par**
- une couche adhérente (32) d'une épaisseur de 2 à 80 nm entre la couche de diamant (24) et la couche de matériau dur (26) et contenant du carbone et au moins un élément métallique, l'élément ou les éléments métalliques de la couche adhérente (32) étant choisis dans un groupe comprenant Ti et Cr,
- la couche adhérente (32) est formée par implantation ou diffusion d'atomes de métal dans une zone extérieure de la couche de diamant (24).

2. Corps enduit selon la revendication 1, dans lequel
- la concentration d'au moins un élément métallique dans la couche adhérente (32) présente un gradient qui augmente avec la distance par rapport au substrat (22) .

3. Corps enduit selon l'une des revendications précédentes, dans lequel
- le ou les éléments métalliques de la couche adhérente (32) sont choisis dans un groupe comprenant Ti et Cr.

4. Corps enduit selon l'une des revendications précédentes, dans lequel
- la couche adhérente (32) est constituée principalement de Ti et de C.

5. Corps enduit selon l'une des revendications précédentes, dans lequel
- la couche adhérente (32) contient un ou plusieurs éléments métalliques de la couche de matériau dur (26) et/ou une couche de transition (33).

6. Corps enduit selon l'une des revendications précédentes, dans lequel
- une couche de transition (33) est prévue entre la couche de diamant (24) et la couche de matériau dur (26), qui contient au moins un élément métallique et au moins un élément non métallique,
- la couche de transition (33) se trouve entre la couche adhérente (32) et la couche de matériau dur (26) .

7. Corps enduit selon l'une des revendications précédentes, dans lequel
- la couche de diamant (24) comporte au moins une couche (30) constituée au moins majoritairement de diamant nanocristallin dont la taille des grains est inférieure ou égale à 100 nm.

8. Corps enduit selon l'une des revendications précédentes, dans lequel
- la couche de diamant (24) comporte au moins une couche (28) constituée au moins majoritairement de diamant dont la taille des grains est supérieure à 100 nm.

9. Corps enduit selon l'une quelconque des revendications précédentes, dans lequel
- la couche de diamant (24) est électriquement non conductrice et la couche adhérente (32) est électriquement conductrice

10. Corps enduit selon l'une quelconque des revendications précédentes, dans lequel
- la couche de matériau dur (26) est formée d'une ou plusieurs couches,
- et au moins une couche est constituée de Ti-Al-N, Ti-N, Ti-C-N, Ti-Al-C-N, Ti-Al-Si-N, Ti-Si-N, Al-Cr-N, Al-Cr-Si-N et/ou Ti-B.

11. Corps enduit selon l'une quelconque des revendications précédentes, dans lequel
- une couche intermédiaire métallique (34) est placée entre le substrat (22) et la couche de diamant (24) ; elle est constituée principalement d'atomes des éléments Cr, W et/ou Ti.

12. Procédé de revêtement d'un corps (10), dans lequel
- une couche de diamant (24) d'une épaisseur de 1 à 40 µm est appliquée sur un substrat (22) au moyen d'un procédé CVD,
- et au-dessus de la couche de diamant (24), au moins une couche de matériau dur (26) est appliquée au moyen d'un procédé PVD,
- dans laquelle la couche de matériau dur (26) est composée d'un ou plusieurs éléments métalliques et d'un ou plusieurs éléments non métalliques,
- dans lequel le ou les éléments métalliques sont choisis dans le groupe comprenant Al, Si et les éléments des groupes 4 à 6 du tableau périodique selon l'UICPA (1988),
- et dans lequel l'élément ou les éléments non métalliques sont choisis dans le groupe comprenant B, N et O
**caractérisé par le fait que**
- une couche adhérente (32) d'une épaisseur de 2 à 80 nm et contenant du carbone et au moins un élément métallique choisi dans un groupe comprenant Ti et Cr est formée entre la couche de diamant (24) et la couche de matériau dur (26) en prétraitant la surface de la couche de diamant (24) par une gravure ionique métallique HIPIMS avant l'application de la couche de matériau dur (26), dans laquelle les ions métalliques sont implantés et/ou se diffusent dans la surface de la couche de diamant (24).

13. Méthode selon la revendication 12, dans laquelle
- la surface de la couche de diamant (24) est traitée avec des ions Ti pendant la gravure par ions métalliques HIPIMS.
